# FASCICULE DE BREVET EUROPEEN

(11) **EP 2 463 230 B1**
(45) Date de publication et mention de la délivrance du brevet: **23.07.2014**
(21) Numéro de dépôt: 10194039.3
(22) Date de dépôt: 07.12.2010
(51) Int. Cl.: B81B 3/00, G02B 26/08

(54) **Elément micromécanique mobile selon au moins un axe de rotation**
Mikromechanisches Element, das um mindestens eine Drehachse beweglich ist
Micromechanical element mobile about at least one axis of rotation

(43) Date de publication de la demande: 13.06.2012
(73) Titulaire: Sercalo Microtechnology Ltd., 9494 Schaan (LI)
(72) Inventeur: Marxer, Cornel, 2000, Neuchâtel (CH); Herbst, Peter, 2067, Chaumont (CH)
(74) Mandataire: Ravenel, Thierry Gérard Louis

(56) Documents cités:
- DE-A1-102006 036 499
- US-B1- 6 736 521

## Description

La présente invention est relative aux microsystèmes électromécaniques, plus connus sous l'appellation MEMS de l'anglais microelectromechanical systems. Elle concerne plus précisément un élément micromécanique mobile selon au moins un axe de rotation.

De tels éléments micromécaniques sont, par exemple, des micro-miroirs utilisés dans des dispositifs de transmission à fibres optiques, tels que des commutateurs, des filtres, ou des démultiplexeurs. Sous forme de matrices, ils équipent, notamment, des commutateurs matriciels (en anglais Optical Cross Connects). De dimension allant de quelques dizaines de micromètres à quelques millimètres, ils sont classiquement fabriqués à partir de plaques de silicium sur isolant, de l'anglais Silicon On Insulator (SOI), par des procédés bien connus de l'homme de métier. Ils comportent une partie mobile en rotation selon au moins un axe, rendue solidaire d'un élément de support, formé d'un cadre, à l'aide de deux poutres élastiques en torsion.

La partie mobile est classiquement actionnée en rotation par des forces électrostatiques (peignes ou capacités à électrodes plates), ou en variante, par des moyens magnétiques, piézoélectriques, ou électromécaniques, à l'aide d'un micro-moteur. Son amplitude de rotation est de l'ordre de 10 à 15 degrés, en fonction de la géométrie des poutres de torsion, en particulier de leur ratio longueur sur largeur, qui détermine la force de rappel appliquée. Ce ratio est généralement compris entre 3 et 30, la largeur étant de l'ordre de 1-3 micromètres, et la longueur de 10 à 30 micromètres.

De par leurs dimensions et en raison des sollicitations dont elles font l'objet, les poutres sont les éléments les plus fragiles de tels dispositifs micromécaniques. Pour des miroirs de grande taille (quelques millimètres) et de masse importante, les poutres de torsion sont, en outre, soumises à des forces importantes lors de chocs ou de fortes accélérations. Ces forces peuvent entraîner la rupture de l'une des poutres, en particulier au niveau de la liaison avec la partie mobile ou le cadre, rendant le dispositif micromécanique inopérant. Des dispositifs antichocs comportant des structures de butée ont donc été développés afin de prévenir ce problème.

L'une de ces structures est divulguée dans le document DE 10 2006 036 499 qui décrit un micro-miroir en silicium comportant une partie mobile raccordée à un cadre à l'aide de deux poutres de torsion, lesquelles comportent une portion renforcée en largeur, solidaire de la partie mobile. Le cadre s'étend rigidement de part et d'autre desdites portions, de façon à former des butées bornant le déplacement latéral des poutres. Lorsqu'une accélération brutale se produit, la partie mobile se déplace latéralement, jusqu'à ce que les portions renforcées des poutres viennent au contact des butées. La déformation des poutres reste en deçà de la limite de zone d'élasticité du silicium, et leur rupture est ainsi évitée.

Ce dispositif est avantageux car il est de structure simple et présente une bonne efficacité. Toutefois, son encombrement représente un inconvénient important. En effet, la partie active du micro-miroir étant constituée de sa partie mobile, et la partie inactive étant le cadre, le ratio surface active sur surface inactive du micro-miroir est faible, en raison de la forte surface occupée par les butées. Or, ce ratio doit être maximisé, essentiellement pour des considérations économiques, en raison des coûts élevés de la matière première et des procédés de fabrication de tels dispositifs.

La présente invention permet de remédier à cet inconvénient, en proposant un micro-dispositif en silicium, comportant une partie active mobile autour d'un axe de rotation et un cadre, dont la surface active est grande par rapport à la surface inactive. Plus précisément, l'invention concerne un élément micro-mécanique comportant un cadre, une partie mobile en rotation à l'intérieur du cadre, autour d'un axe AA, deux poutres de torsion raccordant la partie mobile au cadre, alignées selon l'axe AA et munies d'une portion renforcée en largueur, et des butées disposées de part et d'autre des portions renforcées, de manière à limiter le déplacement latéral de la partie mobile. Selon l'invention, les portions renforcées en largeur sont solidaires du cadre, et les butées sont solidaires de la partie mobile.

Grâce à ces caractéristiques, l'encombrement du cadre peut être réduit par rapport à la surface de la partie mobile, ce qui représente un avantage en termes de coût de fabrication et d'intégration d'un tel dispositif.

Les caractéristiques et avantages de la présente invention ressortiront de la description qui va suivre, faite en regard des dessins annexés, et donnant à titre d'exemple explicatif, mais nullement limitatif, une forme avantageuse de la réalisation d'un élément micro-mécanique selon l'invention, dessins dans lesquels :
- la figure 1 est une vue de dessus d'un premier mode de réalisation d'un élément micro-mécanique selon l'invention,
- la figure 2 est une vue de dessus d'une matrice d'éléments micro-mécaniques selon l'invention,
- la figure 3 représente une variante avantageuse du premier mode de réalisation dudit élément micro-mécanique, et
- la figure 4 représente un deuxième mode de réalisation d'un tel élément micro-mécanique.

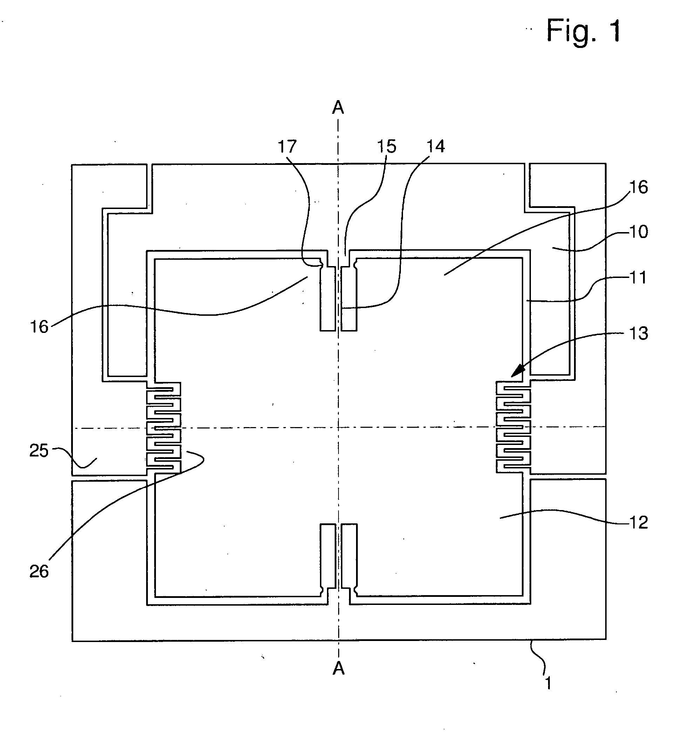

L'élément micro-mécanique représenté en figure 1 et référencé dans son ensemble 1, comporte un cadre fixe 10, délimitant un espace intérieur 11, dans lequel prend place une partie mobile en rotation 12 autour d'un axe géométrique AA. Ladite partie mobile 12 constitue la partie active de l'élément micro-mécanique 1, par opposition à la partie passive, formée par le cadre 10. Elle est constituée, par exemple, d'un micro-miroir, d'une micro-lentille, d'un micro-réseau de diffraction ou de tout autre micro-élément optique ou mécanique de dimension millimétrique ou inférieure. La partie mobile 12 est classiquement raccordée audit cadre 10, par deux poutres de torsion 14 alignées selon l'axe de rotation AA. A l'équilibre, elle est parallèle au plan formé par le cadre fixe 10, mais surélevée par rapport à celui-ci. Les dimensions des poutres 14 sont prévues pour leur conférer une élasticité en torsion déterminée, et une rigidité latérale, c'est-à-dire perpendiculairement à l'axe AA, relativement élevée.

L'élément micro-mécanique 1 comporte encore des électrodes 13 de commande électrostatique de la partie mobile 12, comprenant des premiers peignes 25, solidaires du cadre 10, et surélevés par rapport à la partie mobile 12, et des deuxièmes peignes 26, solidaires de la partie mobile 12. Lesdits peignes 25, 26 s'interpénétrent de façon à exercer une force mutuelle d'attraction ou de répulsion, en fonction du différentiel de potentiel appliqué. Cette force permet d'actionner la partie mobile 12 en rotation autour de l'axe AA. En variante, celle-ci peut être déplacée par divers moyens magnétiques, électromécaniques ou piézoélectriques.

L'ensemble cadre 10 - partie mobile 12 - peignes 25 est formé de matériau semi-conducteur, par exemple, à partir d'une double plaque de silicium sur isolant, comportant un substrat, une première et une deuxième couches minces en silicium, et des couches minces d'oxyde séparant les différents niveaux de silicium. Le cadre 10 est formé dans le substrat, tandis que l'élément mobile 12 et les peignes 25 sont formés, respectivement, dans la première et la deuxième couche de silicium. Les procédés physico-chimiques employés pour la structuration de la double plaque de silicium sur isolant sont bien connus de l'homme de métier. Pour plus de détails sur la technique de fabrication utilisée, on se référera au document WO2008118451.

Le fonctionnement de l'élément micro-mécanique 1 est classique. Lorsque les peignes électrostatiques 25 exercent une force d'attraction sur la partie mobile 12, cette dernière tourne d'un angle de 1 à 15 degrés par rapport à sa position d'équilibre. Lorsque la force d'attraction est désactivée, la partie mobile 12 revient à sa position d'équilibre grâce à la force de rappel exercée par les poutres de torsion 14.

Selon l'invention, les poutres de torsion 14 comportent une portion renforcée en largeur 15 solidaires du cadre 10. Lesdites portions renforcées en largeur 15 sont de longueur comprise typiquement entre un tiers à un dixième de celle des poutres 14. Elles ont, de par leur géométrie, une élasticité en torsion négligeable devant celle des poutres14, et une rigidité latérale très élevée. De plus, la partie mobile 12 s'étend de part et d'autre des poutres de torsion 14, sensiblement parallèlement à l'axe AA, jusqu'en bordure du cadre 10, au voisinage des portions renforcées 15. Elle forme ainsi quatre butées 16, disposées de chaque côté des portions renforcées 15, destinées à limiter les déplacements de la partie mobile 12 perpendiculairement à l'axe de rotation AA. Dans le mode de réalisation décrit en regard de la figure 1, lesdites butées 16 sont rigides. Elles comportent avantageusement des ergots 17 faisant saillie en direction des portions renforcées 15 de manière à s'en rapprocher au maximum. Typiquement, les butées 16 sont distantes de 3 à 15 micromètres des portions renforcées 15.

L'ensemble portions renforcées 15 - butées 16 forme une structure anti-choc destinée à protéger l'élément micro-mécanique 1 des accélérations brutales dans la direction perpendiculaire à l'axe de rotation AA. Son mode d'action est le suivant. Lorsque la partie mobile 12 se déplace perpendiculairement à l'axe de rotation AA, sous l'effet d'un choc ou d'une accélération parasite, les butées 16 viennent au contact des portions renforcées 15, et le mouvement latéral est rapidement bloqué. L'amplitude du déplacement latéral étant faible, les contraintes latérales qui s'exercent sur les poutres de torsion 14 sont limitées, et la vitesse de la partie mobile 12 en fin de course est faible. La rupture des poutres de torsion 14 est ainsi évitée.

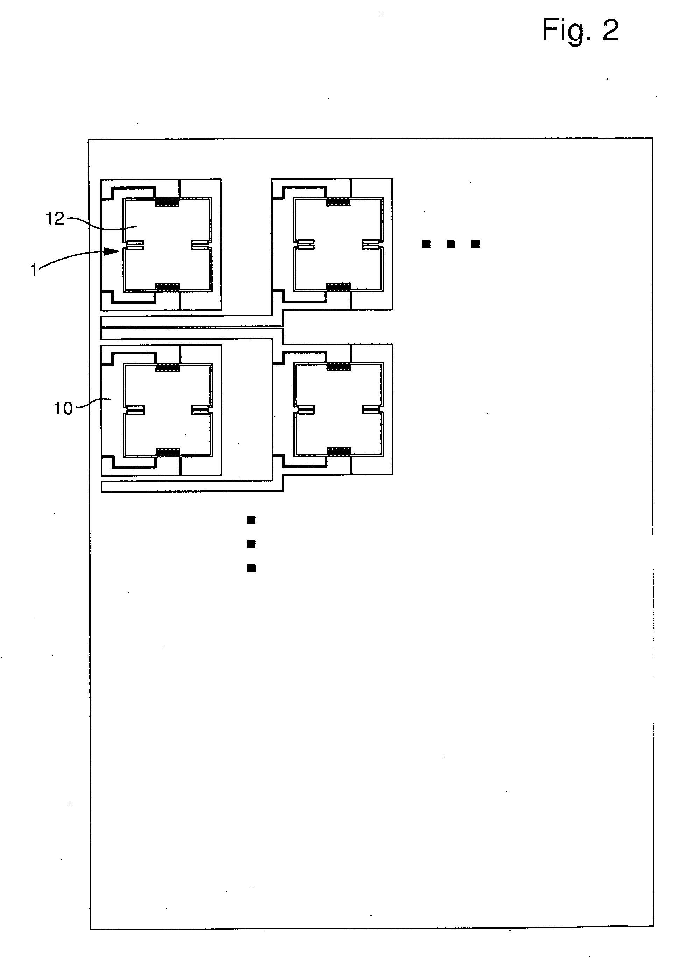

De plus, grâce à la configuration astucieuse des butées 16 et des portions renforcées 15 relativement au cadre 10 et à la partie mobile 12, l'élément micro-mécanique 1 présente un ratio surface active sur surface passive optimum. La partie mobile 12 peut occuper la quasi-totalité de l'espace intérieur 11, y compris l'espace situé de part et d'autre des poutres 14, contrairement à ce qui se fait selon l'état de la technique. Les coûts de fabrication d'un tel élément micro-mécanique s'en trouvent réduits. De plus, l'élément micro-mécanique 1 selon l'invention se prête particulièrement bien à un agencement en matrice, pour lequel, l'économie en surface passive prend toute son importance. Une telle matrice d'éléments micro-mécaniques 1 est illustrée en figure 2.

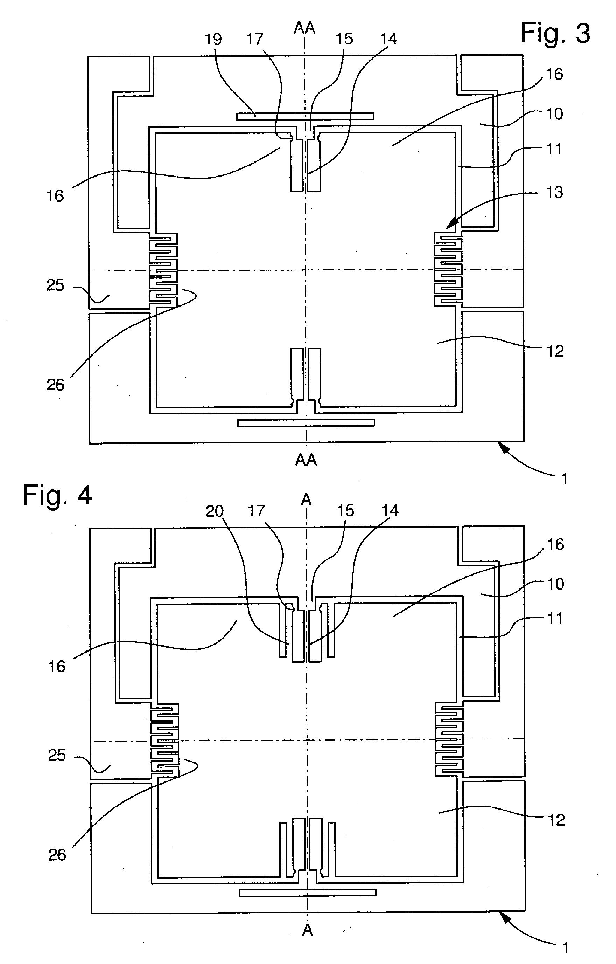

On se réfère maintenant à la figure 3, qui présente une variante avantageuse d'un élément micro-mécanique 1 selon l'invention. Ce mode de réalisation se distingue du précédent en ce que le cadre 10 est, en outre, muni de deux fentes 19 s'étendant au voisinage des portions renforcées 15, perpendiculairement à l'axe AA. Ces fentes 19 confèrent aux poutres de torsion 14, une élasticité longitudinale destinée à absorber d'éventuelles accélérations parallèles à l'axe AA, occasionnées par des chocs.

En figure 4, on a représenté un deuxième mode de réalisation de l'élément micro-mécanique selon l'invention. Dans ce mode de réalisation, les butées 16 comportent un doigt 20 s'étendant parallèlement aux poutres de torsion 14 et présentant une flexibilité perpendiculairement à l'axe AA. Les doigts 20 sont, comme précédemment, munis d'un ergot 17 faisant saillie en direction des portions renforcées 15. Grâce aux doigts 20, et à leur élasticité latérale, le choc entre les butées 16 et les portions renforcées 15 est élastique. Cette propriété permet d'absorber une grande partie de l'énergie du choc sous forme de déformation élastique des doigts 20, ce qui limite les risques éventuels d'adhésion permanente entre la portion renforcée 15 et la partie mobile 12. De plus, l'éventualité d'une casse des butées 16 ou des portions renforcées 15, en cas de choc violent, est diminuée. Le fonctionnement de l'élément micro-mécanique 1 et le rôle des butées 16, ne sont, en dehors de cet aspect, pas modifiés. On notera que, dans ce deuxième mode de réalisation d'un élément micro-mécanique 1 selon l'invention, le cadre 10 peut comporter, comme précédemment, des fentes 19, ayant la même fonction que dans le premier mode de réalisation.

Ainsi a été décrit un élément micro-mécanique 1 mobile autour d'un axe rotation AA, muni d'une structure anti-choc lui conférant un ratio surface active sur surface passive optimum. Bien entendu, la présente invention ne se limite pas aux modes de réalisation décrits ci-dessus, mais s'étend à toutes les variantes à la portée de l'homme de métier, s'inscrivant dans le cadre des revendications ci-après. On notera, en particulier, que l'élément micro-mécanique selon l'invention, peut être mobile selon un premier axe de rotation AA et selon un second axe de rotation BB perpendiculaire à l'axe AA. A cette fin, le cadre 10 est lui-même monté mobile en rotation sur une structure fixe, à l'aide de poutres de torsion.

## Revendications

1. Elément micro-mécanique (1) comportant :
- un cadre (10),
- une partie mobile en rotation (12) à l'intérieur dudit cadre (10), autour d'un axe AA,
- deux poutres de torsion (14) raccordant la partie mobile (12) audit cadre (10), alignées selon l'axe AA et munies d'une portion renforcée en largueur (15), et
- des butées (16) disposées de part et d'autre desdites portions renforcées (15), de manière à limiter le déplacement latéral de la partie mobile (12),
**caractérisé en ce que** lesdites portions renforcées en largeur (15) sont solidaires du cadre (90), et **en ce que** lesdites butées (16) sont solidaires de la partie mobile (12).

2. Elément micro-mécanique (1) selon la revendication 1, **caractérisé en ce que** la partie mobile (12) s'étend de part et d'autre desdites poutres de torsion (14), jusqu'en bordure dudit cadre (10), de manière à former lesdites butées (16).

3. Elément micro-mécanique (1) selon l'une des revendications 1 et 2, **caractérisé en ce que** lesdites butées (16) comportent des ergots (17) s'étendant en direction des portions renforcées (15).

4. Elément micro-mécanique (1) selon l'une des revendications 1 à 3, **caractérisé en ce que** lesdites butées (16) sont rigides perpendiculairement à l'axe de rotation AA.

5. Elément micro-mécanique (1) selon l'une des revendications 1 à 3, **caractérisé en ce que** lesdites butées (16) comportent un bras flexible (20) perpendiculairement à l'axe de rotation AA, s'étendant au voisinage de la portion renforcée (15).

6. Elément micro-mécanique (1) selon l'une des revendications 1 à 5, **caractérisé en ce que** ledit cadre (10) comporte, en outre, deux fentes (19) s'étendant perpendiculairement à l'axe AA au voisinage des portions renforcées (15).

7. Elément micro-mécanique (1) selon l'une des revendications 1 à 6, **caractérisé en ce qu'**il est formé de silicium.

8. Elément micromécanique (1) selon l'une des revendications 1 à 7, **caractérisé en ce que** la partie mobile (12) forme un miroir.

9. élément micro-mécanique (1) selon l'une des revendications 1 à 8, **caractérisé en ce qu'**il est actionné en rotation par des peignes électrostatiques (25, 26).

## Patentansprüche

1. Ein mikro-mechanisches Element (1) umfassend :
- ein Rahmen (10)
- ein in Drehung um eine Achse AA beweglichen Teil (12) innerhalb des Rahmens (10)
- zwei Torsionsbalken (14), welche das bewegliche Teil (12) mit dem genannten Rahmen (10) verbinden, welche entlang der Achse AA ausgerichtet und mit einem in der Breite verstärkten Abschnitt (15) versehen sind, und
- Anschläge (16), welche auf der einen und der anderen Seite der genannten verstärkten Abschnitt (15) derart angeordnet sind, dass die seitliche Auslenkung des beweglichen Teils (12) begrenzt wird,
**dadurch gekennzeichnet, dass** die genannten in der Breite verstärkten Abschnitte (15) mit dem Rahmen (10) verbunden sind, und dass die benannten Anschläge (16) mit dem beweglichen Teil (12) verbunden sind.

2. Mikro-mechanisches Element (1) gemäss Anspruch 1, **dadurch gekennzeichnet, dass** das bewegliche Teil (12) sich auf beiden Seiten der Torsionsbalken (14) derart bis zum Rand des benannten Rahmens (10) ausdehnt, dass sie die genannten Anschläge (16) bilden.

3. Mikro-mechanisches Element (1) gemäss einem der Ansprüche 1 und 2, **dadurch gekennzeichnet, dass** die benannten Anschläge (16) Ansätze (17) aufweisen, welche sich in Richtung der verstärkten Abschnitte (15) ausdehnen.

4. Mikro-mechanisches Element (1) gemäss einem der Ansprüche 1 bis 3, **dadurch gekennzeichnet, dass** die benannten Anschläge (16) steif in die senkrechte Richtung zur Drehachse AA sind.

5. Mikro-mechanisches Element (1) gemäss einem der Ansprüche 1 bis 3, **dadurch gekennzeichnet, dass** die benannten Anschläge (16) einen flexiblen Arm (20) enthalten, welcher senkrecht zur Drehachse AA ausgerichtet ist und sich bis in die Nähe des verstärkten Abschnittes (15) erstrecken.

6. Mikro-mechanisches Element (1) gemäss einem der Ansprüche 1 bis 5, **dadurch gekennzeichnet dass** der benannte Rahmen (10) ausserdem zwei Spalten (19) enthält, welche sich senkrecht zur Drehachse AA in die Nähe der verstärkten Abschnitte (15) erstreckt.

7. Mikro-mechanisches Element (1) gemäss einem der Ansprüche 1 bis 6, **dadurch gekennzeichnet, dass** es aus Silizium besteht.

8. Mikro-mechanisches Element (1) gemäss einem der Ansprüche 1 bis 7, **dadurch gekennzeichnet, dass** der bewegliche Teil (12) einen Spiegel bildet.

9. Mikro-mechanisches Element (1) gemäss einem der Ansprüche 1 bis 8, **dadurch gekennzeichnet, dass** es durch elektrostatische Kämme (25,26) drehbar angetrieben wird.

## Claims

1. Micromechanical element (1) including:
- a frame (10),
- a moving part (12) rotating inside said frame (10), about an axis AA,
- two torsion beams (14) connecting the moving part (12) to said frame (10), aligned on the axis AA and provided with a portion (15) of reinforced width, and
- stop members (16) arranged on both sides of said reinforced portions (15), so as to limit the lateral movement of the moving part (12),
**characterized in that** said portions (15) of reinforced width are integral with the frame (10), and **in that** said stop members (16) are integral with the moving part (12).

2. Micromechanical part (1) according to claim 1, **characterized in that** the moving part (12) extends on both sides of said torsion beams (14) as far as the edge of said frame (10), so as to form said stop members (16).

3. Micromechanical element (1) according to any of claims 1 and 2, **characterized in that** said stop members (16) include catches (17) extending in the direction of the reinforced portions (15).

4. Micromechanical element (1) according to any of claims 1 to 3, **characterized in that** said stop members (16) are rigid perpendicular to the axis of rotation AA.

5. Micromechanical element (1) according to any of claims 1 to 3, **characterized in that** said stop members (16) include a flexible arm (20) perpendicular to the axis of rotation AA extending in proximity to the reinforced portion (15).

6. Micromechanical element (1) according to any of claims 1 to 5, **characterized in that** said frame (10) further includes two slots (19) extending perpendicularly to the axis AA in proximity to the reinforced portions (15).

7. Micromechanical element (1) according to any of claims 1 to 6, **characterized in that** it is formed of silicon.

8. Micromechanical element (1) according to any of claims 1 to 7, **characterized in that** the moving part (12) forms a mirror.

9. Micromechanical element (1) according to any of claims 1 to 8, **characterized in that** it is activated in rotation by electrostatic combs (25, 26).
